Europäisches Patentamt

European Patent Office

Office européen des brevets

(19)

(11) Veröffentlichungsnummer: **0 163 760**
**A2**

(12) **EUROPÄISCHE PATENTANMELDUNG**

(21) Anmeldenummer: **84108726.5**

(51) Int. Cl.⁴: **H 05 K 1/16,** H 05 K 3/10

(22) Anmeldetag: **24.07.84**

(30) Priorität: **05.06.84 DE 3420894**

(71) Anmelder: **NIPPON MEKTRON, LTD., 12-15, 1-Chome Shiba Daimon, Minato-ku Tokyo (JP)**

(43) Veröffentlichungstag der Anmeldung: **11.12.85** Patentblatt **85/50**

(72) Erfinder: **Inoue, Kazuo, 1-7-21 Shiroyama, Toride-Shi Ibaraki-Ken, 302 (JP)**

(84) Benannte Vertragsstaaten: **DE FR GB NL**

(74) Vertreter: **Weissenfeld-Richters, Helga, Dr., Höhnerweg 2, D-6940 Weinheim/Bergstrasse (DE)**

(54) **Gedruckte Schaltung mit integriertem elektronischem Widerstand und Verfahren zu ihrer Herstellung.**

(57) Eine gedruckte Schaltung mit in das Leiterbahnen-System integrierten elektrischen Widerständen wird beschrieben, wobei diese als relativ hochohmige Leiterabschnitte ausgebildet sind. Ferner wird ein Verfahren zur Herstellung solcher gedruckter Schaltungen aufgezeigt, bei welchem die elektrischen Widerstände mit einem gebräuchlichen Maskier- und Plattierverfahren während der Herstellung des gesamten Leiterbahnen-Systems gebildet und in letzteres integriert werden.

EP 0 163 760 A2

# 0163760

Dr. H. Weissenfeld-Richters

Patentanwältin

Höhnerweg 2-4
6940 Weinheim/Bergstr.
Telefon (0 62 01) 80-8618
Telex 4 65 531

23. Juli 1984

Ho/Sch   R 325/Europa

Anmelderin:   Firma Nippon Mektron Ltd., Seiwa Bldg.,
12-15, Shiba Daimon 1-Chome, Minato-Ku,
Tokyo/Japan

## Gedruckte Schaltung mit integriertem elektrischem Widerstand und Verfahren zu ihrer Herstellung

Die Erfindung betrifft eine gedruckte Schaltung mit mindestens einem integrierten elektrischen Widerstand sowie ein Verfahren zu ihrer Herstellung.

Derzeit gebräuchliche Schaltungen dieser Art bestehen beispielsweise aus einem Leiterbahnen-Muster auf einem isolierenden Substrat. Spezielle elektronische Komponenten wie integrierte Schaltkreise, Widerstände oder Kondensatoren sind an bestimmten Stellen dieser Leiterbahnen aufgesteckt und/oder verlötet.

Die Kosten der individuellen Montage dieser elektronischen Komponenten sowie die Teilekosten selbst haben erheblichen Anteil an den Gesamtproduktionskosten für solche Schaltkreise.

Integrierte Schaltungen werden in vermehrtem Maße dort eingesetzt, wo eine Miniaturisierung von Bauteilen angestrebt wird. Die resultierenden beschränkten Platzverhältnisse zwingen daher zur Realisierung immer höherer Leiterbahnendichten, weshalb den elektronischen Komponenten auf gedruckten Schaltkreisen, wie Widerständen, Kondensatoren etc., nur begrenzter Raum zur Verfügung steht. Wichtig ist in diesem Zusammenhang auch die Gesamthöhe einer gedruckten Schaltung, welche zuvorderst von den räumlichen Ausmaßen dieser elektronischen Komponenten bestimmt ist.

Der Erfindung liegt daher die Aufgabe zugrunde, eine gedruckte Schaltung der beschriebenen Art sowie ein Verfahren zu ihrer Herstellung anzugeben, wobei der Einbau von elektronischen Komponenten mit unterschiedlichen elektrischen Widerständen bereits zusammen mit den Verfahrensschritten der relativ kostengünstigen Herstellung der Leiterbahnen vorgenommen werden kann.

Neben dieser Einsparung von Material- und Verfahrenskosten soll zudem ein integrierter Schaltkreis dargelegt werden, dessen räumliche Abmessungen durch die Substitution eines konventionellen, Raum beanspruchenden elektrischen Widerstandes durch eine neuartige Ausführungsform wesentlich verringert sind, um der Forderung nach Miniaturisierung Rechnung zu tragen.

Die erfindungsgemäße Lösung dieser Aufgabe besteht darin, eine gedruckte Schaltung der genannten Art gemäß den Merkmalen im kennzeichnenden Teil des Anspruchs 1 auszubilden, während die dazu vorgesehenen Verfahrensmaßnahmen im Anspruch 10 angegeben sind.

- 3 -

Die erfindungsgemäße Schaltung besteht aus einem ersten, hochohmigen, auf ein isolierendes Substrat aufgetragenen Leiterbahnen-Muster. Dieses ist an den Stellen, wo keine elektrischen Widerstände vorgesehen sind, durch ein zweites, niederohmiges Leitermaterial überlagert. Somit liegt ein Leitersystem vor, welches durch hochohmige, elektrische Widerstände bildende Bahnenabschnitte unterbrochen wird.

Bei einem vorzugsweisen Verfahren gemäß der Erfindung wird zuerst auf einer starren oder flexiblen, isolierenden Grundschicht auf konventionelle Weise das gewünschte komplette Leiterbahnen-Muster aus einer Komponente mit einem spezifischen Widerstand $\varrho$ über 50 $\mu\Omega.cm$ aufgebracht, beispielsweise in einem nicht elektrolytischen, chemischen Plattierverfahren. Man verwendet hierzu vorzugsweise Nickel oder eine Nickellegierung. Anschließend werden die Stellen für die vorgesehenen elektrischen Widerstände mit einem leicht wieder entfernbaren Isolatormaterial maskiert. Im nächsten Schritt wird auf die Fläche ein elektrischer Leiter mit einem spezifischen Widerstand $\varrho$ unter 30 $\mu\Omega.cm$ aufgetragen, vorzugsweise mit dem o.e. Plattierverfahren. Er kann gleichfalls aus Nickel oder Nickellegierungen bestehen. Nach dem entfernen der Masken verbleibt ein erfindungsgemäßes Leiterbahnen-Muster mit integrierten, als Widerstände fungierenden Leiterabschnitten.

Zur näheren Erläuterung dienen die im folgenden beschriebenen Abbildungen:

Figur 1    zeigt den Querschnitt durch eine bekannte Leiterplatte, auf welche in bisher üblicher Weise ein elektrischer Widerstand aufkontaktiert ist.

Figur 2    verdeutlicht die mit (1) bis (5) bezeichneten Verfahrensschritte zur Herstellung einer gedruckten Schaltung gemäß der vorliegenden Erfindung, wobei die Schaltkreiselemente wiederum jeweils im Querschnitt dargestellt sind.

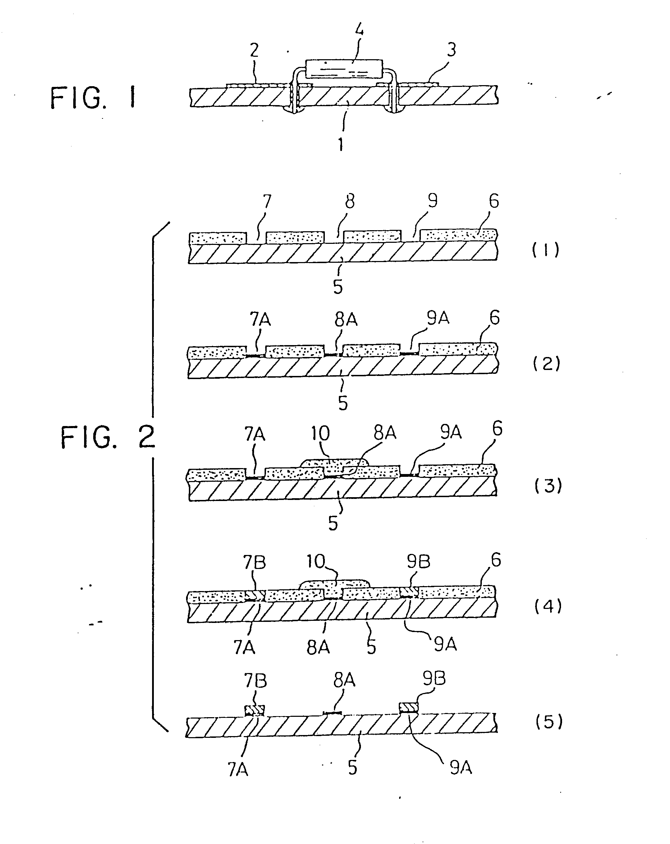

Ein herkömmliches, in Figur 1 gezeigtes Schaltkreiselement besteht aus Leiterbahnen 2 und 3 auf einem isolierenden Substrat 1 sowie aus einem elektronischen Bauteil 4, welches auf die Leiter 2 und 3 aufkontaktiert ist. Solche elektronischen Bauteile 4 sind z.B. integrierte Schaltkreise, Widerstände oder Kondensatoren.

In Figur 2 wird ein erfindungsgemäßes Verfahren skizziert, mit dem ein elektronisches Schaltkreiselement gemäß Anspruch 1 hergestellt werden kann. Dabei sind die Verfahrensstufen (1) bis (5) als bevorzugte Beispiele der Herstellung einer erfindungsgemäßen gedruckten Schaltung zu verstehen, denen keine einschränkende Bedeutung zukommt.

Die isolierende Grundschicht ist konventioneller Art. Sie besteht beispielsweise aus einem harten Material, wie - ggf. glasfaserverstärktem - Epoxid- oder Polyesterharz, Polyimid- oder aushärtbarem bis-Maleinimidharz. Es sind jedoch auch flexible Grundschichten 5 denkbar.

Vor dem ersten Schritt nimmt man vorzugsweise eine Aktivierung der Oberfläche der Grundschicht 5 zur Erleichterung der Maskierung und Plattierung vor. Anschließend wird ein leicht wieder entfernbarer, als Maske dienender elektrischer Isolator mit beispielsweise einem Schablonendruckverfahren in geeigneten Mustern aufgetragen (1), wobei das komplette Leiterbahnen-System des fertigen Schaltkreises frei bleibt. Es entstehen von der Maske 6 nicht bedeckte Einschnitte, z.B. 7, 8 und 9, welche später zur Aufnahme der Leiterbahnen dienen.

Teil (2) der Figur 2 verdeutlicht, wie in die Einschnitte 7, 8 und 9 über ein Plattierverfahren die elektrische Widerstände bildenden Leiterbahnen 7 A, 8 A, 9 A aus z.B. Nickel eingefügt sind. Ihr spezifischer elektrischer Widerstand $\varrho$ beträgt dabei vorzugsweise über 50 $\mu\Omega$.cm, ihre Dicke 0,01 - 20 $\mu$m, vorzugsweise 0,1 - 5 $\mu$m.

Der dritte Herstellungsschritt der vorliegenden Erfindung erhellt aus Figur 2, Teil (3): Das erste hochohmige Leiterbahnen-Muster 7 A - 9 A wird an den als Widerstände vorgesehenen Teilstücken nach einem bei der Leiterplatten-Herstellung gebräuchlichen Verfahren maskiert, d.h. ebenfalls mit einer leicht wieder entfernbaren, isolierenden Schutzschicht 10 versehen. In dieser Zeichnung ist es die Stelle 8 A, auf welche diese Maske 10 aufgetragen worden ist und wo später ein elektrischer Widerstand vorhanden sein soll.

Teil (4) der Figur 2 verdeutlicht, daß im vierten Schritt die unmaskiert gebliebenen Teilbereiche 7 A und 9 A mit einem zweiten, elektrisch gut leitenden Bahnenmuster 7 B, 9 B beschichtet worden sind, dessen spezifischer elektrischer Widerstand $\varrho$ vorzugsweise unter 30 $\mu\Omega$.cm liegt. Wieder können Nickel oder eine Nickellegierung als Plattiermaterial dienen.

Die Gesamtdicke der ersten und zweiten Metallschicht bei 7 und 9 sollte 0,1 - 50 $\mu$m, vorzugsweise 1 - 20 $\mu$m betragen.

Der letzte erfindungsgemäße Verfahrensschritt (5) beinhaltet die Entfernung sämtlicher Masken 6 und 10, wobei jegliche geeignete Methode angewendet werden kann, bei der die Substrat-Grundschicht 5 und die metallischen Komponenten A und B nicht zerstört werden.

Übrig bleibt ein Leiterbahnen-Muster, bestehend aus ein- oder zweischichtigen Abschnitten, von denen die mehrschichtigen (7 B, 9 B) relativ gute Elektronenleiter, die einschichtigen 8 A hingegen elektrische Widerstände mit gleicher Funktion wie Teil 4 in Figur 1 darstellen.

Es soll hier nochmals betont werden, daß die Erfindung keineswegs auf Schaltkreise aus Nickel oder Nickelegierungen beschränkt ist. Ferner sind auch die erwähnten Plattierungsschritte (Metallisierung) lediglich als beispielhaft anzusehen. Der Erfindungsgedanke umfaßt vielmehr zusammenfassend ein Schaltkreiselement sowie ein Verfahren zur seiner Herstellung, bei dem auf ein Substrat ein Leiterbahnenmuster und auf dieses bereichsweise ein zweiter Leiter aufgebracht werden, wobei das erste Leitermaterial einen höheren spezifischen elektrischen Widerstand als das zweite besitzt.

Die vorliegende Erfindung ermöglicht es nicht nur, etliche Verfahrensschritte bei der Bestückung elektronischer Schaltkreise mit Widerständen einzusparen, sie vermindert vielmehr zusätzlich die Material- und Montagekosten für diese Widerstände. Ferner ist es ein wichtiger Vorteil, daß nunmehr die räumlichen Ausmaße einer mit elektrischen Widerständen versehenen Leiterplatte oder -folie wesentlich reduziert und daher die übrigen elektronischen Elemente enger beieinander montiert werden können.

Diese Miniaturisierung erlaubt beispielsweise den Einsatz umfangreicher gedruckter Schaltungen bei unveränderten Einbaumaßen, oder es wird möglich, kleinere Einbauräume für diese Schaltungen vorzusehen. Die eingangs gestellte Aufgabe erweist sich mit der vorliegenden Erfindung somit als zufriedenstellend gelöst.

Bezugszeichenliste

| 1 | Isolierendes Substrat gemäß dem Stand der Technik |
| 2, 3 | Leiterbahnenabschnitte gemäß dem Stand der Technik |
| 4 | elektronisches Bauteil gemäß dem Stand der Technik |
| 5 | isolierende Grundschicht |
| 6 | Isolatormaske für das erste Leiterbahnen-Muster |
| 7, 8, 9 | von der Isolatormaske 6 nicht bedeckte Einschnitte |
| 7 A, 8 A, 9 A | erste, hochohmige Leiterbahnenschicht |
| 7 B, 9 B | zweite, niederohmige Leiterbahnenschicht |
| 10 | isolierende Maske zum Abdecken der Leiterbahnen an der Stelle 8 A |

Ansprüche:

1. Gedruckte Schaltung mit mindestens einem integrierten elektrischen Widerstand, bestehend aus einem auf eine elektrisch isolierende Grundschicht aufgebrachten Leiterbahnen-Muster, dadurch gekennzeichnet, daß alle elektrischen Widerstände als hochohmige, einschichtige Leiterbahnen-Teilstücke (8 A) ausgebildet und in ein Leitersystem integriert sind, dessen elektrisch gut leitende, niederohmige Abschnitte aus einer hochohmigen Leiterschicht (7 A, 9 A) zuunterst und einer niederohmigen Leiterschicht (7 B, 9 B) zuoberst bestehen, welche sich in elektrischem Kontakt zueinander befinden.

2. Gedruckte Schaltung nach Anspruch 1, dadurch gekennzeichnet, daß die hochohmigen Teilstücke (8 A) des Leiterbahnen-Systems einer spezifischen elektrischen Widerstand $\varrho \geq 50\ \mu\Omega.cm$ besitzen.

3. Gedruckte Schaltung nach Anspruch 1 und 2, dadurch gekennzeichnet, daß die niederohmigen Teilstücke des Leiterbahnen-Systems (7 B, 9 B) einen spezifischen elektrischen Widerstand $\varrho \leq 30\ \mu\Omega.cm$ besitzen.

4. Gedruckte Schaltung nach einem oder mehreren der vorhergehenden Ansprüche, dadurch gekennzeichnet, daß die Dicke der hochohmigen Leiterabschnitte (8 A) zwischen 0,01 und 20 μm beträgt.

5. Gedruckte Schaltung nach Anspruch 4, dadurch gekennzeichnet, daß die Dicke der hochohmigen Leiterabschnitte (8 A) zwischen 0,1 und 5 μm beträgt.

6. Gedruckte Schaltung nach einem oder mehreren der vorhergehenden Ansprüche, dadurch gekennzeichnet, daß im zwei- schichtigen Leiterbahnenbereich die Gesamtdicke der elektrischen Leiter (7 A und B, 9 A und B) zwischen 0,1 und 50 µm beträgt.

7. Gedruckte Schaltung nach Anspruch 6, dadurch gekennzeichnet, daß die Gesamtdicke der elektrischen Leiter (7 A und B, 9 A und B) zwischen 1 und 20 µm beträgt.

8. Gedruckte Schaltung nach einem oder mehreren der Ansprüche 1 - 7, dadurch gekennzeichnet, daß eines der beiden Leitermaterialien (A, B) aus Nickel oder einer Nickellegierung besteht.

9. Gedruckte Schaltung nach einem oder mehreren der Ansprüche 1 - 7, dadurch gekennzeichnet, daß beide Leitermaterialien (A B) aus Nickel oder einer Nickellegierung bestehen.

10. Verfahren zur Herstellung einer gedruckten Schaltung nach einem oder mehreren der vorhergehenden Ansprüche, dadurch gekennzeichnet, daß
    - in sich bekannter Weise mittels einer Maske (6) auf eine elektrisch isolierende Grundschicht (5) ein relativ hoch- ohmiges, das gesamte spätere Leitersystem (7, 8, 9) darstellendes Leiterbahnen-Muster (7 A, 8 A, 9 A) aufgetragen wird;
    - auf das erste Leiterbahnen-System an den für die elektrischen Widerstände vorgesehenen Bereichen (8) eine isolierende, leicht wieder ablösbare Maske (10) aufgebracht wird;
    - auf diese teilweise abgedeckte Gesamtfläche ein zweites, relativ niederohmiges Material (7 B, 9 B) aufgetragen wird;
    - sämtliche Masken (6, 10) entfernt werden.

0163760

11. Verfahren nach Anspruch 10, dadurch gekennzeichnet, daß die Oberfläche der elektrisch isolierenden Grundschicht (5) vor dem Aufbringen der Maske (6) einer aktivierenden Oberflächenbehandlung unterzogen wird.

12. Verfahren nach Anspruch 10 oder 11, dadurch gekennzeichnet, daß eine der beiden Leiterbahnen (A, B) durch ein nicht elektrolytisches, chemisches Plattierverfahren aufgetragen wird.

13. Verfahren nach Anspruch 10 oder 11, dadurch gekennzeichnet, daß beide Leiterbahnen, (A, B) durch ein nicht elektrolytisches, chemisches Plattierverfahren aufgetragen werden.

FIG. 1

FIG. 2